Europäisches Patentamt

European Patent Office

Office européen des brevets

(11) Publication number: **0 405 637 A2**

# (12) EUROPEAN PATENT APPLICATION

(21) Application number: **90201536.1**

(22) Date of filing: **14.06.90**

(51) Int. Cl.⁵: **H01L 37/02**

(30) Priority: **20.06.89 GB 8914108**

(43) Date of publication of application: ·
**02.01.91 Bulletin 91/01**

(84) Designated Contracting States:
**DE FR GB**

(71) Applicant: **PHILIPS ELECTRONIC AND
ASSOCIATED INDUSTRIES LIMITED
Philips House 188 Tottenham Court Road
London W1P 9LE(GB)**

(84) **GB**

Applicant: **N.V. Philips' Gloeilampenfabrieken**

Groenewoudseweg 1
NL-5621 BA Eindhoven(NL)

(84) **DE**

(72) Inventor: **Turnbull, Andrew Alfred
c/o Philips Research Laboratories
Redhill, Surrey RH1 5HA(GB)**

(74) Representative: **Stevens, Brian Thomas et al
PHILIPS ELECTRONICS Patents and Trade
Marks Department Philips House 188
Tottenham Court Road
London W1P 9LE(GB)**

(54) **Thermal-radiation detection device manufacture.**

(57) A linear array of infrared detector elements (20) with bottom electrode connections (22) extending away to one side can be formed in situ on a thick but flexible substrate (10), which may be of silicone rubber or other elastic material, by a simple process in accordance with the invention. A body (1) of ferroelectric and/or pyroelectric material is mounted on a conductive layer (2) on an insulating support (10 and 19) comprising the flexible substrate (10). A material-removal step is effected (for example by sawing or ion milling) to divide the body (1) into the detector elements (20) and the conductive layer (2) into the connections (22). Wire bonds (27) can be made on a rigid part (19) of the support, but low microphony characteristics can be achieved with the flexible substrate (10). A top electrode connection (21), which may be carried by a plastics membrane (25) in known manner, is provided at the opposite face (3) of the detector elements (20).

FIG. 1

FIG. 5

EP 0 405 637 A2

# THERMAL-RADIATION DETECTION DEVICE MANUFACTURE

This invention relates to methods of manufacturing a thermal-radiation detection device comprising a group of infrared detector elements of ferroelectric and/or pyroelectric material, particularly but not exclusively one or more linear arrays of detector elements for an inexpensive image sensor. The invention also relates to thermal-radiation detection devices manufactured by such methods.

Thermal-radiation detection devices are known comprising a group of infrared detector elements of ferroelectric and/or pyroelectric material having top and bottom electrode connections to opposite faces. Each bottom electrode connection extends below the respective detector element and away from at least one side of the detector element, for example on a polyimide supporting membrane (flexible film) as described in, for example published European patent application EP-A-0 041 297 (our reference PHB 32707), published UK patent application GB-A-2 100 058 (our reference PHB 32788) and the paper entitled "The application of heat-collector fins to reticulated pyroelectric arrays" by A.A. Turnbull, presented in Cannes, France in November 1985 and published in the Proceedings of SPIE (Society of Photo-Optical Instrumentation Engineers, USA) Vol 588, Recent developments in materials and detectors for the infrared (1985), pages 38 to 43. The whole contents of these two patent applications and the said 1985 SPIE paper are hereby incorporated as reference material in the present specification.

It is known from said 1985 SPIE paper to manufacture such a device by mounting a body of the pyroelectric material (for example ceramic PLMZT, lead lanthanum manganese zirconium titanate) on a substrate, sawing grooves through the thickness of the body to reticulate the material for the individual detector elements, transferring the whole reticulated array in one operation from the substrate to the polyimide membrane which carries the bottom electrode connection pattern, and thereafter providing a top electrode connection (for example carried by a second polyimide membrane which preferably also carries a heat-collector fin). In this manner a high performance pyroelectric detector element array is formed with good thermal isolation and low microphony and in a comparatively inexpensive manner. The fabrication of the polyimide membranes and their mounting is described in some detail in EP-A-0 041 297 and GB-A-2 100 058.

The present invention provides an alternative method of manufacture which may involve less manufacturing steps, avoids an alignment step by avoiding the transfer of the reticulated array to the support and can reduce manufacturing costs.

According to the present invention there is provided a method of manufacturing a thermal-radiation detection device comprising a group of infrared detector elements of ferroelectric and/or pyroelectric material having top and bottom electrode connections to opposite faces, each bottom electrode connection extending below the respective detector element and away from at least one side of the detector element, which method comprises the steps of:

(a) providing an electrically conductive layer on an electrically and thermally insulating support,

(b) mounting a body of the ferroelectric and/or pyroelectric material on an area of the conductive layer so as to provide an electrode connection to an adjacent, bottom face of the body, a part of the conductive layer extending beyond the body, away from at least one side of the body,

(c) removing material through the thickness of the body and through the thickness of the conductive layer both below the body and beyond the body to form grooves which are orientated in at least one direction such as to divide the body into the group of detector elements and to divide the conductive layer into the bottom electrode connections which extend below and away from the detector elements, and

(d) providing a top electrode connection at the opposite face of the detector elements.

In this method, the body of ferroelectric and/or pyroelectric material is reticulated to form the detector elements in situ on the support carrying the bottom electrode connections, and this support may be simpler and less expensive to fabricate than a thin polyimide membrane. The material removal through the body and through the conductive layer may be carried out in various ways. Thus, for example the areas of the body and conductive layer which are to be retained may be covered with a photoresist pattern, and the grooves may be formed by sputter-etching or milling the exposed material with an ion beam. However, sawing is a particularly simple and convenient way to form the grooves and does not require any photoresist or other mask pattern.

Instead of a thin membrane, the support is preferably comparatively thick. It may comprise, for example, a good thermally insulating foam material such as foam plastic or foam glass material. A flexible foam plastic which provides a cushioning layer below the detector elements may be used. The inventor has found it to be particularly advantageous to mount the detector elements on an elastic material such as silicone rubber, for example a silicone rubber available under the Dow Corning trade name Sylgard. A part of the support beyond the detector elements may be rigid to permit wire bonding to the bottom electrode connections. By using a comparatively thick support, the grooves formed through the body and conductive layer (for example by saw cuts) may extend into the support, and the support can be sufficiently thick that (possibly together with a rigid part) it can hold together the group of detector elements in spite of the grooves extending therein. By using a flexible or elastics material to mount the detector elements, this grooved type of support can also provide low microphony and acoustic decoupling between the detector elements. Satisfactory thermal isolation can be achieved especially with high frequency signal read-out and chopping of the incident thermal radiation. In this case, the depth d to which the grooves are cut in the support and the width w of the grooves are preferably such that (2d + w) is at least as large as the thermal diffusion distance for heat flow in the support from the detector elements at the chopping frequency. With these dimensions, the grooves dividing the surface of the support are beneficial in reducing any thermal cross-talk between detector elements via the support.

The body may be of elongate shape having a length and a width, and a row of detector elements may be formed side-by-side along the length of the body by simply forming a group of the grooves each of which extends across the width of the body and across the conductive layer beyond the body. Two rows of the detector elements and their bottom electrode connections may be fabricated from this body and the conductive layer by forming one other groove which extends along the length of the body and intersects said group of grooves.

These and other features in accordance with the invention are illustrated specifically in an embodiment of the invention now to be described, by way of example, with reference to the accompanying diagrammatic drawings. In these drawings:

Figures 1 and 2 show a body mounted on a support at one stage in the manufacture of a thermal-radiation detection device in accordance with the invention, Figure 1 being a cross-section on the line I-I of the plan view of Figure 2;

Figures 3 and 4 show the body and support at a subsequent stage in the manufacture, Figure 4 being a cross-section on the line IV-IV of the plan view of Figure 3;

Figure 5 is a cross-sectional view of the final manufactured device, on the line I-I of Figure 2, and

Figures 6 and 7 are cross-sectional views of two different embodiments at a stage in their manufacture in accordance with the invention, the cross-sections being taken on lines similar to line I-I of Figure 2.

It should be noted that the accompanying drawings are diagrammatic and not drawn to scale. The relative dimensions and proportions of parts of these Figures (especially in the direction of thickness) have been shown exaggerated or reduced in size for the sake of clarity and convenience in the drawings. The same reference signs as used in one embodiment are generally used for referring to corresponding or similar parts in other embodiments.

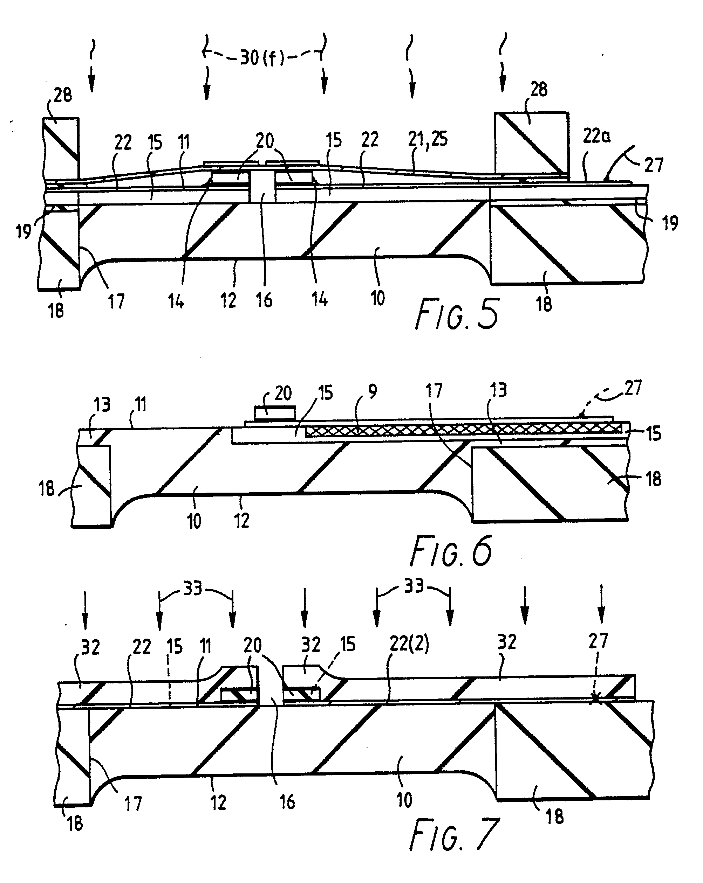

Figure 5 illustrates a thermal-radiation detection device comprising a group of infrared detector elements 20 of ferroelectric and/or pyroelectric material having top and bottom electrode connections 21 and 22 respectively to opposite faces. The infrared radiation 30(f) which is to be detected in known manner is incident at the top of the detector elements 20. Each bottom electrode connection 22 extends below the respective detector element 20 and away from at least one side of the detector element as a conductor track to which an external electrical connection 27 (for example to the gate of a field-effect transistor) can be made for read-out of the signals from the detector element 20.

The device of Figure 5 is manufactured by a method in accordance with the present invention, comprising the steps of:

(a) providing an electrically conductive layer 2 on a face 11 of an electrically and thermally insulating support 10 and 19,

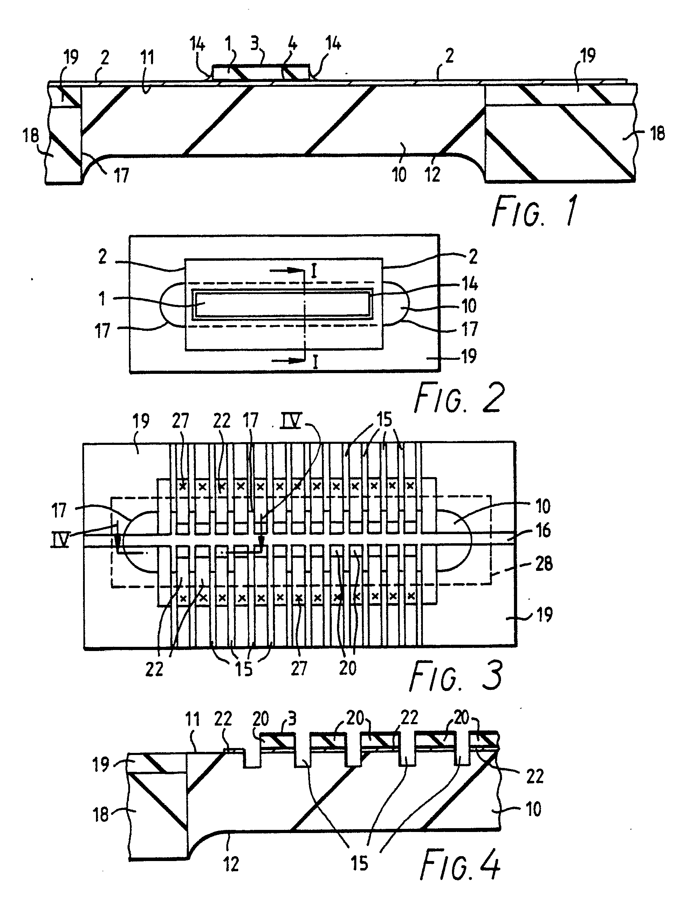

(b) mounting a body 1 of the ferroelectric or pyroelectric material on an area of the conductive layer 2 so as to provide an electrode connection to an adjacent, bottom face 4 of the body 1; a part of the conductive layer 2 extends beyond the body 1, away from at least one side of the body 1 (as illustrated in Figures 1 and 2),

(c) removing material through the thickness of the body 1 and through the thickness of the conductive layer 2 both below the body 1 and beyond the body 1, to form grooves 15 and 16 which are orientated in at least one direction such as to divide the body 1 into the group of detector elements 20 and to divide the conductive layer 2 into the bottom electrode connections 22 which extend below and away from the detector elements 20, (as illustrated in Figures 3, 4 and 5), and

(d) providing a top electrode connection 21 at the opposite face 3 of the detector elements 20 (as illustrated in Figure 5).

In the embodiment illustrated by way of example in Figures 1 to 5, two rows of detector elements 20 are formed back-to-back. Only thirteen detector elements are shown in each row but it should be understood that in a typical thermal-image detection device each row may comprise a linear array of many more, for example, 64 or 128 detector elements 20.

The supporting face 11 of the insulating support 10 and 19 is preferably of an elastic material such as silicone rubber at least below where the body 1 is mounted, so as to reduce microphony in the detector elements 20. However, the conductive layer 2 should also extend on a part of the support 10 and 19 which comprises a rigid material (for example glass), when it is desired to make wire bonds to the electrode connections 22. In the form shown, the insulating support 10 and 19 is of a silicone rubber suspended in an aperture 17 in an apertured rigid mount 18 and 19, for example of glass or having a glass surface layer 19. In this case, at least most of the area of the second face 12 of the flexible support part 10 (opposite that on which the detector elements 20 are mounted) can be free of contact with any rigid mount, and a high flexibility of the support part 10 can be obtained. The silicone rubber may also extend on part of the upper surface of the apertured mount 18 and 19, except where the connections 22 will form wire-bond areas.

In a specific example, the apertured mount 18 and 19 of Figures 1 and 2 may be a preform 18 of, for example, alumina having a glass film 19 thereon. The preform 18 may have a thickness of, for example, about 250 micrometres, and the glass 19 may be, for example, about 100 micrometres thick. In the form illustrated in Figure 2, the aperture 17 is slot-shaped and may be, for example, about 2mm wide by about 1 cm long for two back-to-back rows of 64 elements 20 per row.

Silicone rubbers have a particularly good combination of mechanical, thermal and electrical properties, and in particular durable elasticity and vibration absorption properties and low thermal conductivity. One example of a suitable material is a silicone rubber available under the Dow Corning trade name "Sylgard"; this is formed by mixing together its two liquid components (silicone rubber and catalyst) and flowing the mixture into the aperture 17. Preferably a primer is first applied to the surfaces of the mount 18 and 19 which are required to be bonded to the silicone rubber 10. Suitable primers for use with Sylgard are also available from Dow Corning. The silicone rubber 10 may be moulded in the aperture 7 so that its face 12 (opposite that on which the detector elements 20 are to be mounted) is recessed in the aperture 17 to increase its flexibility. The silicone rubber substrate 10 for the body 1 is formed with a smooth and flat upper face. By way of a specific illustration, with a mount 18 and 19 of thickness 350 micrometres, the flexible silicone-rubber substrate 10 may be, for example about 150 micrometres thick in the area of the aperture 17.

The conductive layer 2 may be deposited in various ways. Preferably a thin seeding layer of, for example, sputtered nickel-chromium is first deposited on the surface 11 of the insulating support 10 and 19, after which gold may be evaporated to form a continous layer of, for example, between 2 and 20nm thickness.

The body 1 may be of any of a wide variety of ferroelectric and/or pyroelectric materials suitable for forming infrared detector elements. Particular examples are: lead zirconate titanate (for example lanthanum-doped lead zirconate titanate, PLZT, or PLMZT), barium titanate, triglycene sulphate (TGS), barium strontium titanate, lead titanate, potassium tantaloniobate, potassium dihydrogen phosphate and Rochelle salt. Before it is mounted on the support 10, the top and bottom faces 3 and 4 of the body 1 are metallized to form thin electrodes which will ensure a good electrical contact with the connection layers 21 and 2(22). This electrode metallization may comprise gold on, for example, a seed layer of nickel chromium. Typical dimensions of an elongate body 1 for two rows each of 64 detector elements 20 are, for example, a width of 300 micrometres, a length of about 7.7mm and a thickness of between about 10 to 40 micrometres.

A thin conductive adhesive layer may then be used to attach the metallized bottom face 4 of the body 1 to the conductor layer 2 on the insulating elastic support 10. In this manner an electrode connection is formed to the bottom face 4. In order to secure the body 1 firmly to the metallized elastic support 10 for a sawing step, an additional coating of silicone rubber or insulating adhesive 14 may be provided along the perimeter of the body 1 as illustrated in Figures 1 and 2. Figures 1 and 2 show the body 1 with the conductive layer 2, mounted on the support 10 and 19.

The grooves 15 and 16 are then formed to divide the body 1 and conductive layer 2 into the group of detector elements 20 and their bottom electrode connections 22. The groove 16 is cut along the length of the body 1, whereas parallel grooves 15 are cut perpendicular thereto across the width of the body 1. All these grooves may be cut with a saw; in this case the width w of grooves is typically about 20 micrometres or more, whereas that of grooves 16 may be about 100 micrometres. The detector elements 20 formed by cutting up the body 1 in this manner may each be, for example, a square area of 100 micrometres by 100 micrometres or less. The grooves 15 and 16 formed by the saw cuts may extend, for example, to a depth d of about 25 micrometres or more into the insulating support 10 and 19. The bottom electrode connections 22 formed by dividing the conductive layer 2 extend away from opposite sides of the group of detector elements 20, as parallel conductor tracks of uniform width on the insulating support 1. The resulting structure is illustrated in Figures 3 and 4.

A top electrode connection 21 is now provided (for example, in known manner) for the detector elements 20. Thus, the connection 21 may be formed by at least one metal conductor carried on the lower surface of a thin plastics film 25. The film 25 may be, for example, a polyimide membrane having a thickness of, for example, about 1 micrometre. The metal conductor(s) 21 may comprise gold, for example about 15nm thick. Preferably the film 25 carries heat-collector fins as described in the 1985 SPIE paper by the present inventor.

Depending on the desired connections, both rows of detector elements 20 may have a common top electrode connection layer 21, or each row may have its own top electrode connection track 21. If desired, one row of detector elements 22 may form the active infrared sensing elements while the other row may be shielded from the incident radiation 30 so as to form compensating elements to provide signal compensation in known manner for the effects of temperature changes and microphony on the active elements. The periphery of the film 25 may be bonded to an apertured mount 28 (the outer perimeter of which is shown in broken outline in the plan view of Figure 3). The mount/film assembly 28 and 25 is bonded to the lower mount 18 and 19, as illustrated in Figure 5, using an insulating adhesive. Wire connections 27 are bonded to the bottom electrode connections 22 on the rigid glass mount part 19. The wire bonds 27 are designated with an 'x' in the plan view of Figure 3.

An advantage of using saw cuts to form the grooves 15 and 16 is that these grooves can readily extend to a sufficient depth d in the elastic substrate 10 to reduce significantly thermal crosstalk between the detector elements 20 through the substrate 10 and to provide significant acoustic decoupling of these elements 20 through the substrate 10.

Normally, the transmission of the thermal-radiation 30 to the detector elements 20 is modulated by a chopper. This results in a limiting distance herein termed the thermal diffusion distance D (the magnitude of which depends on the chopping frequency f) for heat flow in the substrate 10 from the detector elements 20. The concept of a thermal diffusion distance in a chopped pyroelectric infrared detector system is described in the article entitled "Calculation of Temperature Distribution and Temperature Noise in a Pyroelectric Detector - II Evacuated Tube" by R.M. Logan in Infrared Physics (1973) vol. 13, pages 91 to 98 published by Pergamon Press (Great Britain). In this Infrared Physics article (the whole contents of which are hereby incorporated herein as reference material) the concept is described in the context of lateral conduction of heat to and from a detector element area through the surrounding area of the pyroelectric layer in which the detector element is present.

In the context of the present invention, the variations in temperature of the detector elements 20 which correspond to the variations in incident thermal radiation 30 are pulsed by the chopper modulation so that the heat flow into the elastic substrate 10 from the detector elements 20 is also pulsed. Between these heat pulses the heat injected in this manner into the substrate 10 diffuses by conduction through the substrate material at a rate dependent on the thermal conductivity K and volume specific heat c of the substrate material. Due to this diffusion between heat pulses, the parts of the substrate 10 which are further from the detector elements 20 than the thermal diffusion distance D do not experience temperature variations due to the variations in temperature of the detector elements. Thus, these parts of the substrates beyond the distance D from the upper face 11 effectively act as a heat sink. An approximate expression for the thermal diffusion distance D in substrate 10 at the transmission frequency f is given by equation (1):

$$D = K^{\frac{1}{2}} . (\pi c f)^{-\frac{1}{2}} \qquad (1)$$

where D is in cm.

K is in $J.cm^{-1}.K^{-1}.s^{-1}$

c is in $J.cm^{-3}.K^{-1}$

and f is in $s^{-1}$.(Hz).

In a specific example of a silicone rubber having K of about $1.5 \times 10^{-3} J.cm^{-1}.K^{-1}.s^{-1}$., and c of about $1.7 J.cm^{-3}.K^{-1}$., the value for D is about $1.67 \times 10^{-2}.(f)^{-\frac{1}{2}}$. In this specific example, D is about 26 micrometres with a chopper frequency f of 40Hz and about 53 micrometres with f of 10Hz.

By cutting the grooves 15 and 16 in the elastic substrate 10 with a width w and depth d such that (2d + w) is larger than D, the temperature variations of one detector element are not transmitted through the substrate 10 to a neighbouring detector element. This provides a better reduction in thermal cross-talk than the use of a thin membrane as the substrate. However, it should be noted that thermal conduction between the elements 20 in the specific detector of Figure 5 can still occur along the top membrane 25 carrying the top electrode connection 21.

The grooves 15 and 16 may cut into the elastic substrate 10 to a depth d less than the thermal diffusion distance D. However, it is generally preferable for the depth d of the grooves 15 and 16 in the elastic substrate 10 to be between 25 and 50 micrometres, or more. Thus, by making d at least as large as approximately D, thermal losses from each detector element 20 to the effective heat sink are minimised by laterally confining the extent of the heat sink of each detector element 20 by means of the grooves 15 and 16. The responsivity of the detector elements 20 can be improved in this manner. Having such deep grooves 15 and 16 also increases the flexibility of the parts of the elastic substrate 10 forming the flexible platform areas on which the detector elements 20 are mounted and provides good acoustic decoupling between these detector elements 20 due to the elasticity and vibration absorption properties of the elastic material 10 over the increased acoustic path length (2d + w) between the detector elements 20.

In the form illustrated in Figures 1 to 5, the silicone rubber 10 does not extend to any great extent on the upper surface of the mount 18,19. However, in some devices a part 13 of the silicone rubber 10 may extend several tens or even hundreds of micrometres along the upper surface of the mount 18 and may be comparatively thick (for example about 50 micrometres or more) in this area. Figure 6 illustrates one such arrangement in which the elastic substrate 10 has a thinner glass mount 9 embedded in an area of the first face 11 of the elastic substrate 10 to one side of the detector elements 20. The conductor tracks 22 extend on the glass mount 9 and.on the face 11 of the silicone rubber 10 below the detector elements 20. By way of a simple illustration, Figure 6 shows a cross-section (similar in location to that of Figure 5) for a detector with a single row of elements 20. A cross-section of this detector taken perpendicular to Figure 6 may be the same in construction as that of Figure 4 except that a silicone rubber part 13 replaces the glass part 19. Thus, the detector elements 20 and tracks 22 of the Figure 6 device may be separated by grooves formed by parallel saw cuts 15 of width w which extend to the depth d in the silicone rubber substrate 10 and its embedded glass plate 9. Wire connections 27 can be made to the conductor tracks 22 on the glass plate 9. The edge of the plate 9 as visible in the groove 15 is double-hatched in Figure 6 for clarity of understanding, even though the cross-section of Figure 6 is not taken through this plate 9.

In the Figure 6 embodiment, the detector elements 20 are mounted on the metallized face 11 of the elastic substrate 10. However, it is also possible to mount the detector elements 20 on a metallized face 11 of a platform 9 of a material which in itself may be less flexible. The platform 9 may be, for example, a glass plate or a polyimide layer or a layer of a softer plastics material than polyimide, and it may overlie and be supported on an elastic substrate 10 (for example, of silicone rubber) to provide acoustic damping in the mounting arrangement for the detector elements 20. The grooves 15 (and 16) may extend into the glass plate 9 or plastics layer 9 to a depth d less than the thickness of the plate or layer 9, or these grooves may be cut deeper so as to extend into the underlying elastic substrate 10.

A particularly low-microphony mounting arrangement for the detector elements 20 is obtained when mounted on an elastic material at the surface 11 of the substrate 10. The second face 12 of an elastic substrate 10 may be at least substantially free of contact with a rigid support over the area where the group of detector elements 20 are located. Such a situation occurs with the apertured mount 18,19 of Figures 1 to 5. However in detectors in accordance with the invention the second face 12 of the grooved elastic substrate 10 may be present on a rigid base, for example a glass plate or an envelope base or a circuit board/substrate. Silicone rubber has a high flexibility. However the substrate 10 may comprise other materials, for example a flexible foam plastics material. It may be formed by coating or bonding the insulating material 10 to a base plate which may be of glass or, for example, the base of a device envelope, or a circuit board, depending on the particular construction of thermal-image sensing device being manufactured.

Instead of cutting with a saw, the grooves 15 and 16 may be formed in other ways, for example using ion milling (e.g. with argon ions) to sputter away the body material 1 and conductive layer material 2 except where covered by a masking layer pattern 32 of, for example photoresist or a suitable metal. Such a situation is illustrated in Figure 7. An advantage of using an ion beam 33 to etch the grooves 15 and 16 is that (by chosing the desired geometry in the masking layer pattern), the grooves 15 and 16 can easily be made with different widths over different lengths of each groove and with bends in each groove (i.e. a groove which is not simply a single straight line). In this way most of the length of the track 22 may be made narrower than the part of the conductor 22 below the detector element 20 and the track 22 may expand at its opposite end to form a wide bond area to which an external wire connection 27 may be bonded at x.

Many modifications and variations are possible within the scope of the present invention. In most applications of the invention, the material of the body 1 and the design and circuit operation of the detector elements 20 are likely to be chosen so as to utilize the conventional pyroelectric effect in which when a temperature change occurs (for example upon absorption of incident infrared radiation 30 of a thermal image) in a polar crystalline material exhibiting spontaneous polarization, the crystalline material generates electric charges at its opposite faces. By arranging the pyroelectric crystalline material in known manner as a capacitor (with electrodes at the opposite faces 3 and 4) in a suitable amplifying circuit, a current or voltage signal can be developed and detected. Most of the useful pyroelectric materials are also ferroelectric and exhibit their pyroelectric properties in the ferroelectric phase below their Curie point transition temperature. However, infrared detectors may also be constructed in known manner using ferroelectric materials operating in the region of their Curie point where their dielectric constant changes rapidly with temperature. Such ferroelectric infrared detector elements may also be constructed as capacitors with electrode connections 21 and 22 at opposite faces 3 and 4. Both these pyroelectric and ferroelectric types of detector elements 20 (together with their bottom electrode connections 22) can be manufactured in groups on an insulating support 10 and 19 (or 9) by methods in accordance with the present invention and both benefit in similar ways from good thermal isolation and the low microphony provided by fabrication on an elastic insulator 10.

From reading the present disclosure, other variations will be apparent to persons skilled in the art. Such variations may involve equivalents and other features which are already known in the design, manufacture and use of thermal-radiation detection devices, groups of infrared detector elements of ferroelectric and/or pyroelectric material and component parts thereof and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

**Claims**

1. A method of manufacturing a thermal-radiation detection device comprising a group of infrared detector elements of ferroelectric and/or pyroelectric material having top and bottom electrode connections to opposite faces, each bottom electrode connection extending below the respective detector element and away from at least one side of the detector element, which method comprises the steps of:

(a) providing an electrically conductive layer on an electrically and thermally insulating support,

(b) mounting a body of the ferroelectric and/or pyroelectric material on an area of the conductive layer so as to provide an electrode connection to an adjacent, bottom face of the body, a part of the conductive layer extending beyond the body, away from at least one side of the body,

(c) removing material through the thickness of the body and through the thickness of the conductive layer both below the body and beyond the body to form grooves which are orientated in at least one direction such as to divide the body into the group of detector elements and to divide the conductive layer into the bottom electrode connections which extend below and away from the detector elements, and

(d) providing a top electrode connection at the opposite face of the detector elements.

2. A method as claimed in claim 1, wherein the body is of elongate shape having a length and a width, and a row of detector elements are formed side-by-side along the length of the body by a group of the grooves each of which extends across the width of the body and across the conductive layer beyond the body.

3. A method as claimed in claim 2, wherein one groove extends along the length of the body and intersects said group of grooves so as to form two rows of the detector elements and their bottom electrode connections.

4. A method as claimed in any one of the preceding claims, wherein the material removal step (c) is performed using ion milling to form the grooves.

5. A method as claimed in any one of claims 1 to 3, wherein the grooves formed through the body and the conductive layer extend into the support.

6. A method as claimed in claim 5, wherein the grooves are formed by saw cuts through the body and conductive layer and into the support.

7. A method as claimed in any one of the preceding claims, wherein the face of the support on which the conductive layer is provided comprises a rigid material at least to said one side of the body, and wire connections are made to the electrode connections on the rigid material after step (c).

8. A method as claimed in any one of the preceding claims, wherein the face of the support on which the conductive layer is provided comprises a flexible material at least below where the body is to be mounted.

9. A method as claimed in claim 8, wherein the flexible material is a silicone rubber.

10. A method as claimed in claim 8, wherein the flexible material is a flexible foam plastics material.

FIG. 1

FIG. 2

FIG. 3

FIG.4

FIG. 5

FIG. 6

FIG. 7